# EUROPEAN PATENT APPLICATION

(11) **EP 4 303 694 A1**
(43) Date of publication of application: **10.01.2024**
(21) Application number: 23182723.9
(22) Date of filing: 30.06.2023
(51) Int. Cl.: G06F 1/16

(54) **SUPPORT MEMBER FOR DISPLAY DEVICE AND DISPLAY DEVICE INCLUDING THE SAME**

(30) Priority: 08.07.2022 KR 20220084470
(71) Applicant: Samsung Display Co., Ltd., Yongin-si, Gyeonggi-do 17113 (KR)
(72) Inventor: HA, Seung Wa, Yongin-si (KR); KIM, Do Youb, Yongin-si (KR); JUNG, Seung-Ho, Yongin-si (KR)
(74) Representative: Marks & Clerk LLP

(57) **Abstract**

A support member for a display device includes: a first surface and a second surface opposite to each other; an outer pattern at the first surface, and extending longer in a first direction; and an inner pattern at the second surface, and extending longer in the first direction. The outer pattern and the inner pattern are staggered with each other.

## Description

### BACKGROUND

### 1. Field

Embodiments of the present disclosure relate to a support member for a display device, and a display device including the support member.

### 2. Description of the Related Art

A display device is a device for displaying an image, and includes a liquid crystal display (LCD), an organic light emitting diode (OLED) display, and the like.

The display device is used in various suitable electronic devices, such as a mobile phone, a navigation device, a digital camera, an electronic book, a portable game machine, and various suitable terminals.

Recently, a flexible display device that may have reduced weight and thickness, may increase portability, and may be bent or folded, is being developed. The flexible display device may be implemented by using a flexible substrate, such as a plastic substrate, instead of a glass substrate.

In addition, a support member may be attached to one surface of a display panel to protect the display device.

The above information disclosed in this Background section is for enhancement of understanding of the background of the present disclosure, and therefore, it may contain information that does not constitute prior art.

### SUMMARY

In a process of folding and/or bending a flexible display device, stress may be applied to a folding area of a support member, which may affect a durability of the display device.

Embodiments of the present disclosure are directed to a support member that may stably protect a display panel in a process of folding and/or bending a flexible display device, and a display device including the support member.

According to one or more embodiments of the present disclosure, a support member for a display device includes: a first surface and a second surface opposite to each other; an outer pattern at the first surface, and extending longer in a first direction; and an inner pattern at the second surface, and extending longer in the first direction. The outer pattern and the inner pattern are staggered with each other.

In an embodiment, the support member may include a first area, a second area, and a third area between the first area and the second area in a plan view; the support member may be configured to be folded along a folding axis parallel to the first direction in the third area; and the outer pattern and the inner pattern may be located in the third area.

In an embodiment, in a state in which the support member is folded, the first surface may face toward the outside, and the second surface may face toward the inside.

In an embodiment, the outer pattern may have a shape of a groove recessed from the first surface of the support member; the inner pattern may have a shape of a groove recessed from the second surface of the support member; and a hole penetrating the support member may be located in a portion in which the outer pattern and the inner pattern overlap with each other.

In an embodiment, the outer pattern and the inner pattern may have a bar shape or a rhombus shape in a plan view.

In an embodiment, the outer pattern may include a plurality of outer patterns adjacent to one another along the first direction, and a second direction crossing the first direction; and the inner pattern may include a plurality of inner patterns adjacent to one another along the first direction and the second direction.

In an embodiment, the support member may further include: an outer bridge between the plurality of the outer patterns; and an inner bridge between the plurality of the inner patterns.

In an embodiment, the outer bridge and the inner bridge may be located in a zigzag shape.

In an embodiment, the outer bridge and the inner bridge may be located along an imaginary line extending in the second direction.

In an embodiment, a ratio of a depth of the outer pattern to a thickness of the support member may be 60% or more, and 70% or less; and a ratio of a depth of the inner pattern to the thickness of the support member may be 30% or more, and 40% or less.

In an embodiment, a width of the outer pattern may decrease as a depth of the outer pattern increases from the first surface; and a width of the inner pattern may decrease as a depth of the inner pattern increases from the second surface.

In an embodiment, the support member may include a first sub-support member and a second sub-support member that overlap with each other; the outer pattern may be located at the first sub-support member; and the inner pattern may be located at the second sub-support member.

In an embodiment, the support member may further include an adhesive member between the first sub-support member and the second sub-support member.

According to one or more embodiments of the present disclosure, a display device includes: a display panel configured to display an image; and a support member on one surface of the display panel. The support member includes: a first surface and a second surface opposite to each other; an outer pattern at the first surface, and extending longer in a first direction; and an inner pattern at the second surface, and extending longer in the first direction. The outer pattern and the inner pattern are staggered with each other.

In an embodiment, the support member may include a first area, a second area, and a third area between the first area and the second area in a plan view; the support member may be configured to be folded along a folding axis parallel to the first direction in the third area; and the outer pattern and the inner pattern may be located in the third area.

In an embodiment, in a state in which the support member is folded, the first surface may face toward the outside, and the second surface may face toward the inside.

In an embodiment, the outer pattern may have a shape of a groove recessed from the first surface of the support member; the inner pattern may have a shape of a groove recessed from the second surface of the support member; and a hole penetrating the support member may be located in a portion in which the outer pattern and the inner pattern overlap with each other.

In an embodiment, the outer pattern and the inner pattern may have a bar shape or a rhombus shape in a plan view.

In an embodiment, the outer pattern may include a plurality of outer patterns adjacent to one another along the first direction, and a second direction crossing the first direction; and the inner pattern may include a plurality of inner patterns adjacent to one another along the first direction and the second direction.

In an embodiment, the support member may include: an outer bridge between the plurality of outer patterns; and an inner bridge between the plurality of inner patterns, and the outer bridge and the inner bridge may be located in a zigzag shape, or along a line.

At least some of the above and other features of the invention are set out in the claims.

According to one or more embodiments of the present disclosure, it may be possible to stably protect a display panel in a process of folding and/or bending a flexible display device.

### BRIEF DESCRIPTION OF THE DRAWINGS

The above and other aspects and features of the present disclosure will be more clearly understood from the following detailed description of the illustrative, nonlimiting embodiments with reference to the accompanying drawings.
FIG. 1 illustrates an exploded perspective view of a display device according to an embodiment.
FIG. 2 illustrates a cross-sectional view of a display device according to an embodiment.
FIG. 3 illustrates a cross-sectional view of a display device in a folded state according to an embodiment.
FIG. 4 illustrates a top plan view of a support member of a display device according to an embodiment.
FIG. 5 illustrates a top plan view of one surface of a partial area of a support member of a display device according to an embodiment.
FIG. 6 illustrates an enlarged view of a portion of FIG. 5.
FIG. 7 illustrates a top plan view of another surface of a partial area of a support member of a display device according to an embodiment.
FIG. 8 illustrates an enlarged view of a portion of FIG. 7.
FIG. 9 illustrates a perspective view of a partial area of a support member of a display device according to an embodiment.
FIG. 10 illustrates a view taken along the line X-X of FIG. 9.
FIG. 11 illustrates a cross-sectional view taken along the line X-X of FIG. 9.
FIG. 12 illustrates a view taken along the line XII-XII of FIG. 9.
FIG. 13 illustrates a cross-sectional view taken along the line XII-XII of FIG. 9.
FIG. 14 illustrates a cross-sectional view of a support member for a display device according to an embodiment.
FIG. 15 illustrates a cross-sectional view of a support member for a display device according to a comparative example.
FIG. 16 illustrates a top plan view of a partial area of a support member for a display device according to an embodiment.
FIG. 17 and FIG. 18 illustrate cross-sectional views of a partial area of a support member for a display device according to one or more embodiments.
FIG. 19 illustrates a top plan view of one surface of a partial area of a support member for a display device according to an embodiment.
FIG. 20 illustrates a top plan view of another surface of a partial area of a support member for a display device according to an embodiment.
FIG. 21 illustrates a perspective view of a partial area of a support member of a display device according to an embodiment.
FIG. 22 illustrates a view taken along the line XXII-XXII of FIG. 21.
FIG. 23 illustrates a cross-sectional view taken along the line XXII-XXII of FIG. 21.
FIG. 24 illustrates a view taken along the line XXIV-XXIV of FIG. 21.
FIG. 25 illustrates a cross-sectional view taken along the line XXIV-XXIV of FIG. 21.
FIG. 26 illustrates a top plan view of a partial area of a support member for a display device according to an embodiment.
FIG. 27 illustrates a top plan view of one surface of a partial area of a support member for a display device according to an embodiment.
FIG. 28 illustrates a top plan view of another surface of a partial area of a support member for a display device according to an embodiment.
FIG. 29 illustrates a perspective view of a partial area of a support member of a display device according to an embodiment.
FIG. 30 illustrates a view taken along the line XXX-XXX of FIG. 29.
FIG. 31 illustrates a view taken along the line XXXI-XXXI of FIG. 29.
FIG. 32-FIG. 37 illustrate cross-sectional views of a partial area of a support member for a display device according to one or more embodiments.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

In the figures, the x-axis, the y-axis, and the z-axis are not limited to three axes of the rectangular coordinate system, and may be interpreted in a broader sense. For example, the x-axis, the y-axis, and the z-axis may be perpendicular to or substantially perpendicular to one another, or may represent different directions from each other that are not perpendicular to one another.

As used herein, the phrases "in a plan view" and "on a plane" refer to a view of a target portion from the top, and the phrases "in a cross-sectional view" and "on a cross-section" refers to a view of a cross-section formed by vertically cutting a target portion from the side.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the terms "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

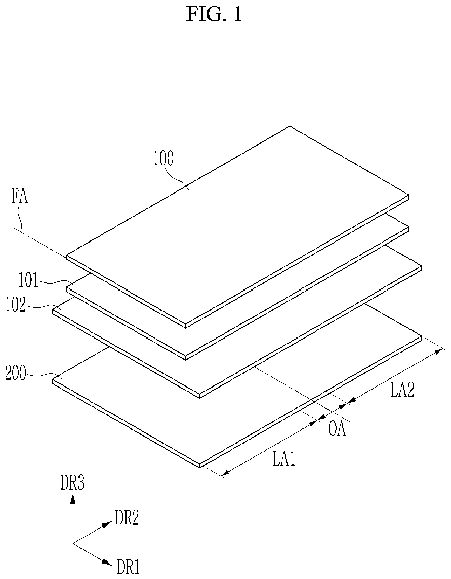

First, a display device according to one or more embodiments of the present disclosure will be described in more detail with reference to FIG. 1 through FIG. 3.

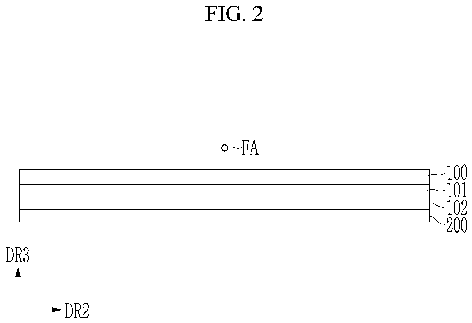

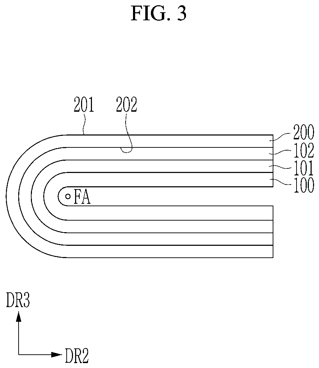

FIG. 1 illustrates an exploded perspective view of a display device according to an embodiment. FIG. 2 illustrates a cross-sectional view of a display device according to an embodiment. FIG. 3 illustrates a cross-sectional view of a display device in a folded state according to an embodiment.

Referring to FIG. 1 through FIG. 3, a display device according to one or more embodiments includes a display panel 100 for displaying an image, and a support member 200 positioned on one surface of the display panel 100. A protective member 101 may be further positioned between the display panel 100 and the support member 200, and an adhesive member 102 may be further positioned between the protective member 101 and the support member 200.

The display panel 100 may be formed to have a quadrangular shape including two sides that are parallel to or substantially parallel to a first direction DR1, and two sides that are parallel to or substantially parallel to a second direction DR2 crossing (e.g., perpendicular to or substantially perpendicular to) the first direction DR1, in a plan view. However, the shape of the display panel 100 is not limited thereto, and the shape of the display panel 100 may be variously modified as needed or desired. For example, the display panel 100 may be formed to have another polygonal shape, a circular shape, or an elliptical shape. In addition, a corner portion of the display panel 100 may be chamfered with a curved line or a straight line. The display panel 100 may have a suitable thickness (e.g., a predetermined thickness) in a third direction DR3 perpendicular to or substantially perpendicular to the first direction DR1 and the second direction DR2.

The display panel 100 may include (e.g., may be made of) a flexible material to be changed into various shapes. The display panel 100 may be flexible, stretchable, foldable, bendable, or rollable. In the present embodiment, an example in which the display panel 100 is foldable will be mainly described in more detail. FIG. 2 illustrates a view before the display device is folded according to an embodiment, and FIG. 3 illustrates a view after the display device is folded according to an embodiment.

The display panel 100 may be folded along a folding axis FA that is parallel to or substantially parallel to the first direction DR1. In the state in which the display panel 100 is folded, portions of the display panel 100 positioned at both sides of the folding axis FA may face each other. In this case, the display panel 100 may be folded so that image displaying surfaces thereof face each other. However, the present disclosure is not limited thereto, and a surface on which an image is displayed may be positioned toward the outside. In other words, the display panel 100 may be folded so that surfaces on which no image is displayed face each other. In addition, the portions of the display panel 100 positioned at both sides of the folding axis FA may be folded to have a suitable angle (e.g., a predetermined angle) therebetween. For example, the portions of the display panel 100 positioned at both sides of the folding axis FA may be folded and/or fixed in a state of having an angle of about 45 degrees, about 90 degrees, or about 135 degrees.

The display panel 100 may be formed of an organic light emitting display panel. The display panel 100 may include a substrate, and a plurality of pixels including a transistor positioned on the substrate, and a light emitting diode connected to the transistor. The plurality of pixels may be arranged in various suitable forms, and, for example, may be arranged in a matrix form along the first direction DR1 and the second direction DR2. However, the kind of the display panel 100 is not limited thereto, and the display panel 100 may be formed as various suitable kinds of panels. For example, the display panel 100 may be formed as a liquid crystal panel, an electrophoretic display panel, an electrowetting display panel, or the like. In addition, the display panel 100 may be a next-generation display panel, such as a micro light emitting diode (LED) display panel, a quantum dot light emitting diode (QLED) display panel, and a quantum dot organic light emitting diode (QD-OLED) display panel.

In some embodiments, a polarization layer, a cover window, and the like may be further positioned on the display panel 100.

The support member 200 may be positioned below (e.g., underneath) the display panel 100. The support member 200 and the display panel 100 may overlap with each other, so as to be adjacent to each other in the third direction DR3. The support member 200 may have a planar shape similar to that of the display panel 100. For example, the support member 200 may be formed to have a rectangular shape including two sides that are parallel to or substantially parallel to the first direction DR1, and two sides that are parallel to or substantially parallel to the second direction DR2, in a plan view. However, the present disclosure is not limited thereto, and the planar shapes of the support member 200 and the display panel 100 may be different from each other.

The support member 200 may include (e.g., may be made of) a flexible material to be changed into various suitable shapes. The support member 200 may be flexible, stretchable, foldable, bendable, or rollable. In the present embodiment, a case in which the support member 200 is foldable will be mainly described in more detail. The support member 200 may be folded along the folding axis FA that is parallel to or substantially parallel to the first direction DR1. The support member 200 may include a first area LA1, a second area LA2, and a third area OA positioned between the first area LA1 and the second area LA2. The third area OA of the support member 200 may be folded along the folding axis FA. The first area LA1 and the second area LA2 of the support member 200 may not be folded, and may maintain a flat or substantially flat shape. In a state in which the support member 200 is folded, the first area LA1 and the second area LA2 may overlap with each other.

The support member 200 includes a first surface 201 and a second surface 202 opposite to each other. The second surface 202 of the support member 200 may be positioned closer to the display panel 100 than the first surface 201 thereof. The second surface 202 of the support member 200 may be in contact with the adhesive member 102. In the state in which the display device is folded, the first surface 201 of the support member 200 is positioned at the outermost side, and may have a shape surrounding the remaining constituent elements. The second surface 202 of the support member 200 is positioned more inside with respect to the first surface 201. The first surface 201 of the support member 200 may be referred to as an outer surface, and the second surface 202 may be referred to as an inner surface.

The support member 200 may include (e.g., may be made of) a metal material or a non-metal material. The non-metal material may include, for example, carbon fiber reinforced plastic (CFRP), glass fiber reinforced plastic (GFRP), aramid fiber reinforced plastic (AFRP), or the like.

The protective member 101 may be disposed under the display panel 100 to support the display panel 100, and may protect the display panel 100 from external impacts. The protective member 101 may have a planar shape similar to that of the display panel 100. The protective member 101 may overlap with the display panel 100 in the third direction DR3. The protective member 101 may include (e.g., may be made of) a polymer resin. For example, the protective member 101 may include a polymer resin, such as polyethersulfone, polyacrylate, polyether imide, polyethylene naphthalate, polyethylene terephthalate, polyphenylene sulfide, polyarylate, polyimide, polycarbonate, or cellulose acetate propionate.

The adhesive member 102 may be positioned between the protective member 101 and the support member 200 to allow the support member 200 to be attached to the protective member 101. The adhesive member 102 may have a planar shape similar to that of the display panel 100. The adhesive member 102 may overlap with the display panel 100 in the third direction DR3. When the display device is folded, the support member 200 may be fixed to the display panel 100 and the protective member 101 to be folded together therewith.

The display device according to an embodiment may further include a digitizer. A digitizer is a device for encoding and inputting a positional relationship of a picture or a figure, and when a pen is moved on the upper surface of the display device, coordinate information is converted into digital data to be input. The digitizer may be used to input drawings, diagrams, design drawings, and the like. The digitizer may be positioned under the protective member 101 or the support member 200. The digitizer may overlap with the display panel 100 in the third direction DR3.

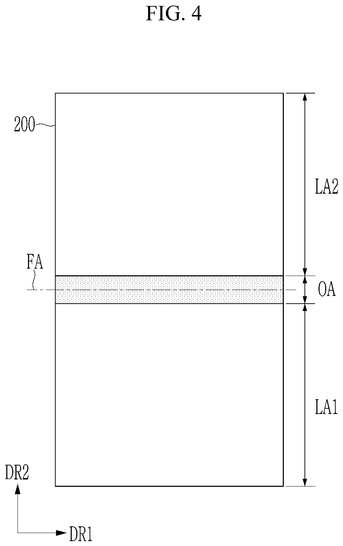

Hereinafter, the support member 200 of the display device according to one or more embodiments will be described in more detail with reference to FIG. 4 through FIG. 13.

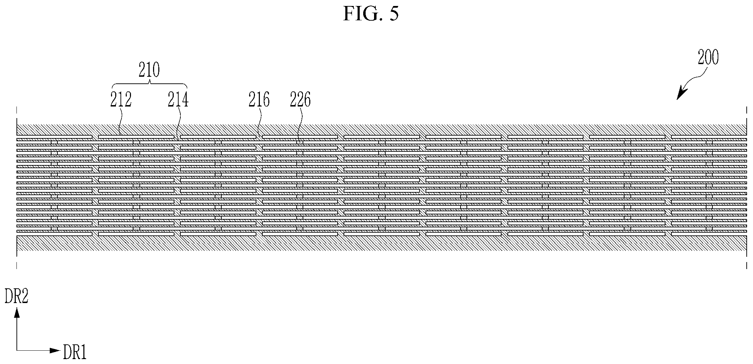

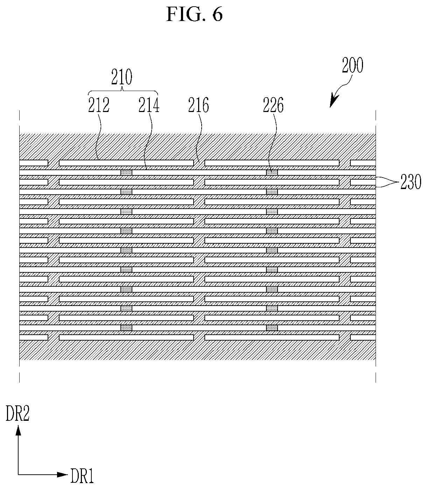

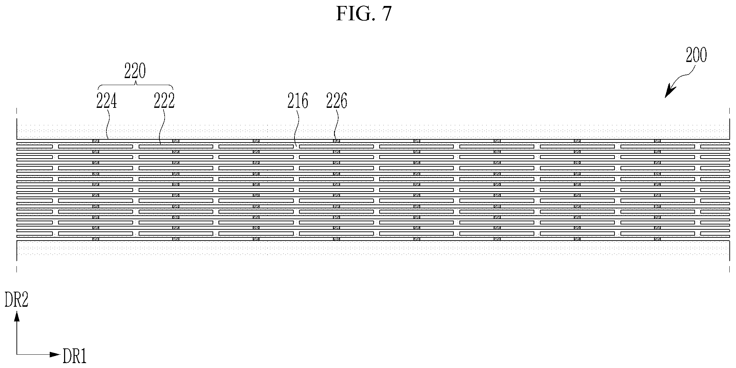

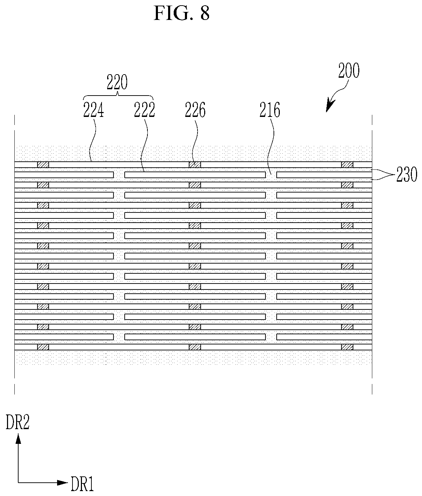

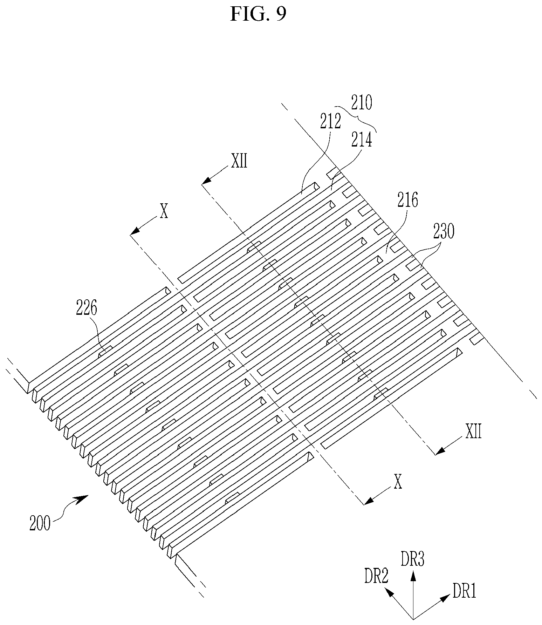

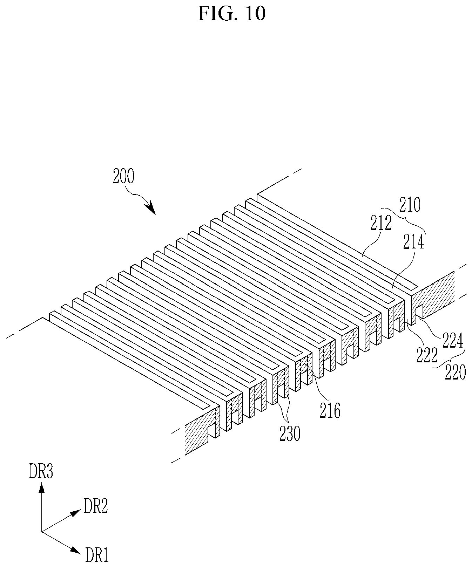

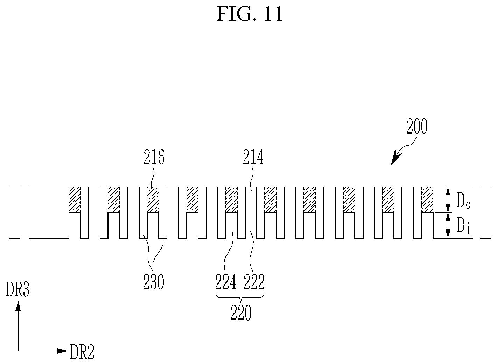

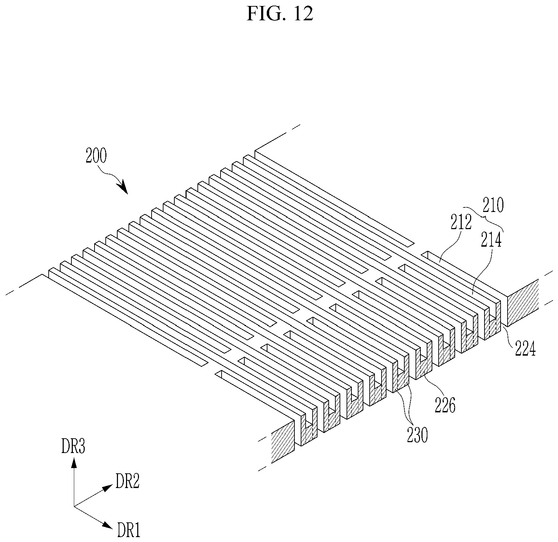

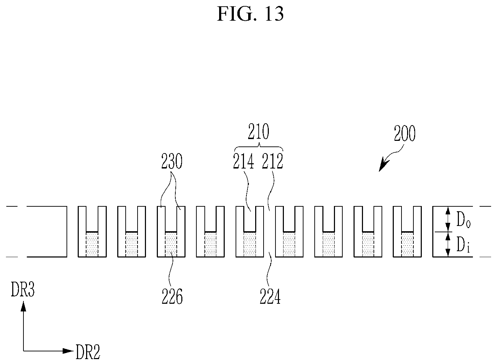

FIG. 4 illustrates a top plan view of a support member of a display device according to an embodiment. FIG. 5 illustrates a top plan view of one surface of a partial area of a support member of a display device according to an embodiment, and FIG. 6 illustrates an enlarged view of a portion of FIG. 5. FIG. 7 illustrates a top plan view of another surface of a partial area of a support member of a display device according to an embodiment, and FIG. 8 illustrates an enlarged view of a portion of FIG. 7. FIG. 5 through FIG. 8 illustrate the third area OA of the support member of the display device according to one or more embodiments. FIG. 5 and FIG. 6 illustrate the first surface 201, or in other words, the outer surface, of the support member of the display device according to an embodiment. FIG. 7 and FIG. 8 illustrate the second surface 202, or in other words, the inner surface, of the support member of the display device according to an embodiment. FIG. 9 illustrates a perspective view of a partial area of a support member of a display device according to an embodiment. FIG. 10 illustrates a view taken along the line X-X of FIG. 9, and FIG. 11 illustrates a cross-sectional view taken along the line X-X of FIG. 9. FIG. 12 illustrates a view taken along the line XII-XII of FIG. 9, and FIG. 13 illustrates a cross-sectional view taken along the line XII-XII of FIG. 9. FIG. 9 is illustrated in a direction for viewing the first surface of the support member of the display device.

Referring to FIG. 4, the support member 200 may include the first area LA1, the second area LA2, and the third area OA positioned between the first area LA1 and the second area LA2. The third area OA of the support member 200 may be folded (e.g., foldable) along the folding axis FA. In an unfolded state of the display device, the first area LA1 and the second area LA2 may be adjacent to each other in the second direction DR2. In a folded state of the display device, the first area LA1 and the second area LA2 may be adjacent to each other in the third direction DR3, and may overlap with each other.

Referring to FIG. 5 and FIG. 6, the support member 200 of the display device includes an outer pattern 210 positioned in the third area OA. The outer pattern 210 may be positioned at (e.g., in or on) the first surface 201 of the support member 200. The outer pattern 210 may have a groove shape recessed to have a suitable depth (e.g., a predetermined depth) from a surface of the first surface 201 of the support member 200. The outer pattern 210 may extend longer in the first direction DR1 in a plan view. The outer pattern 210 may have a bar shape extending longer in the first direction DR1 in a plan view. However, a planar shape of the outer pattern 210 is not limited thereto, and may be variously modified as needed or desired. The support member 200 may include a plurality of outer patterns 210. The plurality of outer patterns 210 may be disposed along the first direction DR1 and the second direction DR2.

The outer pattern 210 may include a first outer pattern 212 and a second outer pattern 214. A length in the first direction DR1 of the first outer pattern 212 may be smaller than a length in the first direction DR1 of the second outer pattern 214. The length in the first direction DR1 of the second outer pattern 214 may correspond to (e.g., may be the same or substantially the same as) a length in the first direction DR1 of the support member 200. The first outer pattern 212 and the second outer pattern 214 may be alternately disposed along the second direction DR2 in a plan view. For example, the first outer pattern 212 may be disposed in odd-numbered rows, and the second outer pattern 214 may be disposed in even-numbered rows. In this case, nine first outer patterns 212 may be disposed to be spaced apart from each other with a suitable interval (e.g., a predetermined interval) therebetween in the odd-numbered rows. One second outer pattern 214 may be disposed between two adjacent first outer patterns 212 in each of the even-numbered rows. However, the present disclosure is not limited thereto, and the number of the first outer patterns 212 and the number of the second outer patterns 214 disposed in each row may be variously modified as needed or desired. Accordingly, the lengths of the first outer pattern 212 and the second outer pattern 214 may be variously modified as needed or desired.

The support member 200 may include a plurality of ribs 230 extending longer in the first direction DR1, and outer bridges 216 connecting the ribs 230 to each other. A rib 230 may be positioned between the first outer pattern 212 and the second outer pattern 214. In other words, the first outer pattern 212 and the second outer pattern 214 are separated from each other by the rib 230. The outer bridge 216 may be positioned between a plurality of first outer patterns 212 that are disposed to be spaced apart from each other along the first direction DR1. In other words, the plurality of first outer patterns 212 are separated from each other by the outer bridge 216.

At opposite end portions (e.g., in the first direction DR1) of the third area OA of the support member 200, end portions of the ribs 230 may not be connected to each other. In other words, the outer pattern 210 positioned at the opposite end portions of the third area OA of the support member 200 may be opened. No bridge may be positioned at the opposite end portions of the third area OA of the support member 200.

As shown in FIG. 7 and FIG. 8, the support member 200 of the display device according to an embodiment includes an inner pattern 220 positioned in the third area OA. The inner pattern 220 may be positioned at (e.g., in or on) the second surface 202 of the support member 200. The inner pattern 220 may have a groove shape recessed to have a suitable depth (e.g., a predetermined depth) from a surface of the second surface 202 of the support member 200. The inner pattern 220 may extend longer in the first direction DR1 in a plan view. The inner pattern 220 may have a bar shape extending longer in the first direction DR1 in a plan view. However, a planar shape of the inner pattern 220 is not limited thereto, and may be variously modified as needed or desired. The support member 200 may include a plurality of inner patterns 220. The plurality of inner patterns 220 may be disposed along the first direction DR1 and the second direction DR2.

The inner pattern 220 may include a first inner pattern 222 and a second inner pattern 224. A length in the first direction DR1 of the first inner pattern 222 may be smaller than a length in the first direction DR1 of the second inner pattern 224. The length in the first direction DR1 of the second inner pattern 224 may correspond to (e.g., may be the same or substantially the same as) a length in the first direction DR1 of the support member 200. The first inner pattern 222 and the second inner pattern 224 may be alternately disposed along the second direction DR2 in a plan view. For example, the first inner pattern 222 may be disposed in the even-numbered rows, and the second inner pattern 224 may be disposed in the odd-numbered rows. In this case, nine first inner patterns 222 may be disposed to be spaced apart from each other with a suitable interval (e.g., a predetermined interval) therebetween in the even-numbered rows. One second inner pattern 224 may be disposed between two adjacent first inner patterns 222 in each of the odd-numbered rows. However, the present disclosure is not limited thereto, and the number of the first inner patterns 222 and the number of the second inner patterns 224 disposed in each row may be variously modified as needed or desired. Accordingly, the lengths of the first inner pattern 222 and the second inner pattern 224 may be variously modified as needed or desired.

The support member 200 may include a plurality of ribs 230 extending longer in the first direction DR1, and inner bridges 226 connecting the ribs 230 to each other. A rib 230 may be positioned between the first inner pattern 222 and the second inner pattern 224. In other words, the first inner pattern 222 and the second inner pattern 224 are separated from each other by the rib 230. The inner bridge 226 may be positioned between a plurality of first inner patterns 222 that are disposed to be spaced apart from each other along the first direction DR1. In other words, the plurality of first inner patterns 222 are separated from each other by the inner bridge 226.

At opposite end portions (e.g., in the first direction DR1) of the third area OA of the support member 200, end portions of the ribs 230 may not be connected to each other. In other words, the inner pattern 220 positioned at the opposite end portions of the third area OA of the support member 200 may be opened. No bridge may be positioned at the opposite end portions of the third area OA of the support member 200.

The outer pattern 210 and the inner pattern 220 are disposed to be staggered. Accordingly, referring to the first surface 201 of the support member 200, the outer pattern 210 and the inner bridge 226 overlap with each other. In this case, the second outer pattern 214 may overlap with the inner bridge 226. In addition, referring to the second surface 202 of the support member 200, the inner pattern 220 and the outer bridge 216 overlap with each other. In this case, the second inner pattern 224 may overlap with the outer bridge 216. In the third area OA of the support member 200, the first outer pattern 212, the outer bridge 216, and the second inner pattern 224 may be positioned in the odd-numbered rows. In addition, the second outer pattern 214, the first inner pattern 222, and the inner bridge 226 may be positioned in the even-numbered rows.

The outer pattern 210 and the inner pattern 220 may overlap with each other in at least a partial area. A hole passing through (e.g., penetrating) the support member 200 may be formed at a position at which the outer pattern 210 and the inner pattern 220 overlap with each other. In this case, a sum of a depth of the outer pattern 210 and a depth of the inner pattern 220 may correspond to a thickness of the support member 200. The depths of the outer pattern 210 and the inner pattern 220 and the thickness of the support member 200 will be described in more detail below.

Referring to FIG. 9 through FIG. 13, the support member 200 of the display device according to an embodiment includes the outer pattern 210 and the inner pattern 220 that are disposed to be staggered. Between the outer patterns 210, the rib 230 and the outer bridge 216 may be positioned. Between the inner patterns 220, the rib 230 and the inner bridge 226 may be positioned.

The ribs 230 that are adjacent to each other may be connected to each other by the outer bridge 216. In this case, the second inner pattern 224 may have a shape surrounded (e.g., around a periphery thereof) by the rib 230 and the outer bridge 216. For example, both lateral sides of the second inner pattern 224 may be covered by the rib 230, and an upper side thereof may be covered by the outer bridge 216. The second outer pattern 214 and the first inner pattern 222 may overlap with each other to form a hole.

The ribs 230 that are adjacent to each other may be connected to each other by the inner bridge 226. In this case, the second outer pattern 214 may have a shape surrounded (e.g., around a periphery thereof) by the rib 230 and the inner bridge 226. For example, both lateral sides of the second outer pattern 214 may be covered by the rib 230, and a lower side thereof may be covered by the inner bridge 226. The first outer pattern 212 and the second inner pattern 224 may overlap with each other to form a hole.

The outer pattern 210 and the inner pattern 220 may be formed by performing a suitable process (e.g., a predetermined process) on the support member 200. For example, the outer pattern 210 and the inner pattern 220 may be formed in the support member 200 by using a micro blast process, a wet etching process, or the like. The outer pattern 210 may be formed by processing the first surface 201 of the support member 200, and the inner pattern 220 may be formed by processing the second surface 202 of the support member 200. The process of forming the outer pattern 210 in the support member 200 and the process of forming the inner pattern 220 in the support member 200 may be concurrently (e.g., simultaneously or substantially simultaneously) performed with each other. However, the present disclosure is not limited thereto, and the process of forming the outer pattern 210 and the process of forming the inner pattern 220 may be separately performed from each other.

The outer bridge 216 and/or the inner bridge 226 may be positioned in a portion in which the outer pattern 210 and the inner pattern 220 do not overlap with each other. A depth Dₒ of the outer pattern 210 may correspond to a thickness of the outer bridge 216. In other words, the depth Dₒ of the outer pattern 210 may be the same or substantially the same as the thickness of the outer bridge 216. A depth of the first outer pattern 212 and a depth of the second outer pattern 214 may be the same or substantially the same as each other. A depth Dᵢ of the inner pattern 220 may correspond to a thickness of the inner bridge 226. In other words, the depth Dᵢ of the inner pattern 220 may be the same or substantially the same as the thickness of the inner bridge 226. A depth of the first inner pattern 222 and a depth of the second inner pattern 224 may be the same or substantially the same as each other.

A sum of the depth Dₒ of the outer pattern 210 and the depth Dᵢ of the inner pattern 220 may correspond to the thickness of the support member 200. In other words, the sum of the depth Dₒ of the outer pattern 210 and the depth Dᵢ of the inner pattern 220 may be the same or substantially the same as the thickness of the support member 200. The depth Dₒ of the outer pattern 210 and the depth Dᵢ of the inner pattern 220 are illustrated as being similar to (e.g., the same or substantially the same as) each other, but the present disclosure is not limited thereto. The depth Dₒ of the outer pattern 210 and the depth Dᵢ of the inner pattern 220 may be the same or substantially the same as each other, or may be different from each other. For example, a ratio of the depth Dₒ of the outer pattern 210 to the thickness of the support member 200 may be about 60% or more, and about 70% or less. In this case, a ratio of the depth Dᵢ of the inner pattern 220 to the thickness of the support member 200 may be about 30% or more, and about 40% or less. When the depth Dₒ of the outer pattern 210 is relatively larger than the depth Dᵢ of the inner pattern 220, it may be possible to reduce stress applied to the third area OA of the support member 200 when the display device is folded.

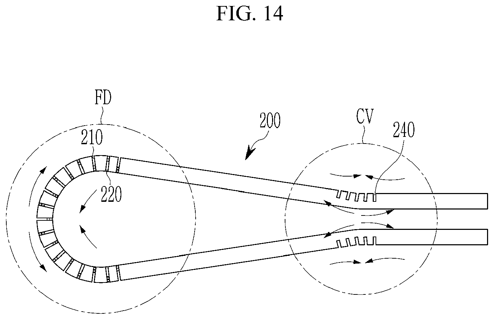

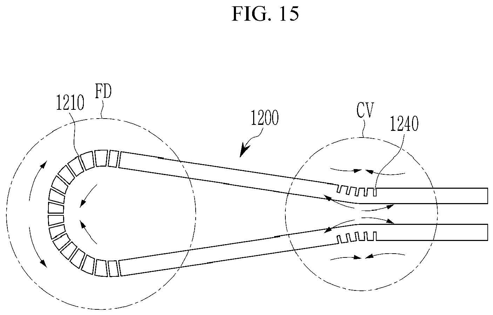

Hereinafter, a support member for a display device according to an embodiment of the present disclosure and a support member for a display device according to a comparative example will be described in more detail with reference to FIG. 14 and FIG. 15.

FIG. 14 illustrates a cross-sectional view of a support member for a display device according to an embodiment. FIG. 15 illustrates a cross-sectional view of a support member for a display device according to a comparative example.

As shown in FIG. 14, the support member 200 for the display device according to an embodiment of the present disclosure may include a folding portion FD that is bent with a suitable curvature (e.g., a predetermined curvature). A tensile stress is applied to an outer surface of the folding portion FD to extend the folding portion FD, and a compressive stress is applied to an inner surface of the folding portion FD to contract the folding portion FD. In the folding portion FD, the outer pattern 210 and the inner pattern 220 that are disposed to be staggered are formed. In some areas of the folding portion FD, the outer pattern 210 and the inner pattern 220 overlap with each other, and in some other areas of the folding portion FD, the outer pattern 210 and the inner pattern 220 do not overlap with each other. The folding portion FD of the support member may be smoothly bent by the outer pattern 210 and the inner pattern 220, and may have a stable curvature. The support member for the display device according to the present embodiment may further include a curved portion CV that is bent with a suitable curvature (e.g., a predetermined curvature). The curved portion CV may be bent in an opposite direction to that of the folding portion FD. A compressive stress is applied to an outer surface of the curved portion CV to contract the curved portion CV, and a tensile stress is applied to an inner surface of the curved portion CV to stretch the curved portion CV. A pattern (e.g., a predetermined pattern) 240 may be formed at (e.g., in or on) the curved portion CV, and in this case, the pattern 240 having a suitable depth (e.g., a predetermined depth) may be formed at (e.g., in or on) an outer surface thereof. In this case, the depth of the pattern 240 may correspond to (e.g., may be the same or substantially the same as) the depth of the outer pattern 210 of the support member 200.

As shown in FIG. 15, a support member 1200 for a display device according to the comparative example may include a folding portion FD and a curved portion CV. A hole 1210 passing through the support member 1200 may be formed in the folding portion FD, and a predetermined pattern 1240 may be formed in the curved portion CV. In the folding portion FD of the support member 1200 for the display device according to the comparative example, no separate pattern is formed at (e.g., in or on) an outer surface and an inner surface thereof, and a single hole 1210 pattern may be formed therein. Therefore, in order to form a width of the hole 1210 to be a desired width (e.g., a predetermined or certain width) or less, there may be a limit in increasing a thickness of the support member 1200. As another example, in order to increase the thickness of the support member 1200, a process may be possible only when the width of the hole 1210 is greater than or equal to a predetermined or certain width. When the width of the hole 1210 is increased, a curvature of the folding portion FD may not be stably formed. In other words, a problem such as the folding portion FD being crushed may occur.

In the support member 200 for display device according to one or more embodiments of the present disclosure, by separately forming the outer pattern 210 and the inner pattern 220 from each other at (e.g., in or on) both surfaces of the support member 200, the width of the pattern may be reduced to be a desired width (e.g., a predetermined or certain width) or less, and the curvature of the folding portion FD may be stably formed. In addition, by disposing the outer pattern 210 and the inner pattern 220 to be staggered, the folding portion FD may be more smoothly bent.

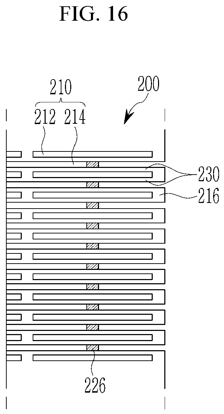

Next, a support member for a display device according to an embodiment will be described in more detail with reference to FIG. 16.

Because many portions of the support member for the display device according to the embodiment illustrated in FIG. 16 are the same or substantially the same as those of the embodiments of the support member described above with reference to FIG. 4 through FIG. 13, redundant description thereof may not be repeated. The present embodiment may be different from those described above, in that end portions of a rib may be connected to each other, which will be described in more detail below.

FIG. 16 illustrates a top plan view of a partial area of a support member for a display device according to an embodiment.

As shown in FIG. 16, the support member 200 for the display device according to an embodiment includes the outer pattern 210 and the inner pattern. The outer pattern 210 may include the first outer pattern 212 and the second outer pattern 214. The outer bridge 216 may be positioned between the first outer patterns 212, and the second outer pattern 214 may overlap with the inner bridge 226. The rib 230 may be positioned between the first outer pattern 212 and the second outer pattern 214.

In the embodiments described above, the end portions of the ribs 230 of the support member 200 may not be connected to each other. However, in the present embodiment, the end portions of the ribs 230 of the support member 200 may be connected to each other. For example, the rib 230 positioned above and the rib 230 positioned below the first outer pattern 212 positioned at the end portion of the support member 200 may be connected to each other. In other words, the outer bridge 216 may be positioned at the end portion of the support member 200. Accordingly, the first outer pattern 212 positioned at the end portion of the support member 200 may be closed. The second outer pattern 214 at the end portion of the support member 200 is illustrated as being opened, but the present disclosure is not limited thereto. For example, the second outer pattern 214 may also have a closed shape. In other words, the rib 230 positioned at the upper side of the second outer pattern 214 and the rib 230 positioned at the lower side of the second outer pattern 214 may be connected to each other.

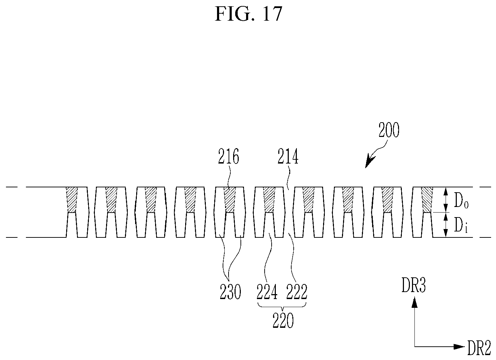

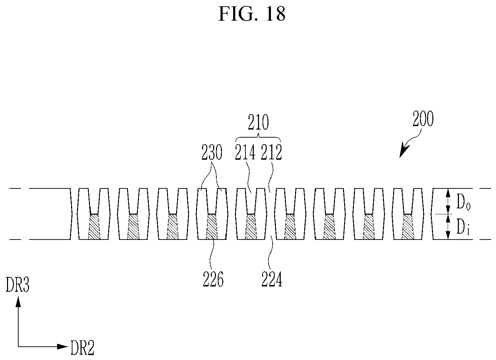

Hereinafter, a support member for a display device according to an embodiment will be described in more detail with reference to FIG. 17 and FIG. 18.

Because many portions of the support member for the display device according to the embodiments illustrated in FIG. 17 and FIG. 18 are the same or substantially the same as those of the embodiments of the support member described above with reference to FIG. 4 to FIG. 13, redundant description thereof may not be repeated. The present embodiment may be different from those described above, in that the widths of the outer pattern and the inner pattern in the second direction DR2 may not be constant, which will be described in more detail below.

FIG. 17 and FIG. 18 illustrate cross-sectional views of a partial area of a support member for a display device according to one or more embodiments.

As shown in FIG. 17 and FIG. 18, the support member 200 for the display device according to one or more embodiments includes the outer pattern 210 and the inner pattern 220 that are disposed to be staggered. Between the outer patterns 210, the rib 230 and the outer bridge 216 may be positioned. Between the inner patterns 220, the rib 230 and the inner bridge 226 may be positioned.

The ribs 230 that are adjacent to each other may be connected to each other by the outer bridge 216. In this case, the second inner pattern 224 may have a shape surrounded (e.g., around a periphery thereof) by the ribs 230 and the outer bridge 216. The ribs 230 that are adjacent to each other may be connected to each other by the inner bridge 226. In this case, the second outer pattern 214 may have a shape surrounded (e.g., around a periphery thereof) by the ribs 230 and the inner bridge 226.

In the embodiments described above, the outer pattern 210 and the inner pattern 220 may have a constant or substantially constant width in the second direction DR2, while in the present embodiment, the outer pattern 210 and the inner pattern 220 may not have a constant width in the second direction DR2.

The width of the outer pattern 210 may gradually decrease in the second direction DR2 as the outer pattern 210 deepens along the third direction DR3. In other words, the side surface of the outer pattern 210 may have a tapered shape. The width of the inner pattern 220 may gradually decrease in the second direction DR2 as the inner pattern 220 deepens along the third direction DR3. In other words, the side surface of the inner pattern 220 may have a tapered shape. A hole passing through (e.g., penetrating) the support member 200 is formed at a position at which the outer pattern 210 and the inner pattern 220 overlap with each other, and a cross-section of the hole may have an hourglass shape. A portion in which the second outer pattern 214 and the first inner pattern 222 overlap with each other may have an hourglass-shaped cross-section. In addition, a portion in which the first outer pattern 212 and the second inner pattern 224 overlap with each other may have an hourglass-shaped cross-section.

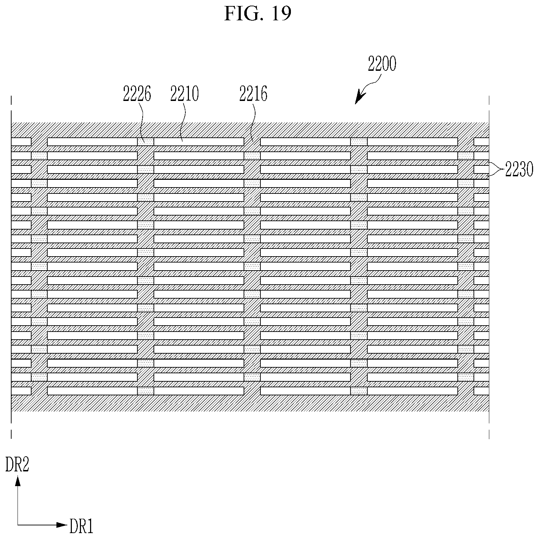

Hereinafter, a support member for a display device according to one or more embodiments will be described in more detail with reference to FIG. 19 through FIG. 25.

Because many portions of the support member for the display device according to the embodiments illustrated in FIG. 19 to FIG. 25 are the same or substantially the same as those of the embodiments of the support member described above with reference to FIG. 4 to FIG. 13, redundant description thereof may not be repeated. In the present embodiment, the shapes of the outer pattern and the inner pattern may be different from those described above, which will be described in more detail below.

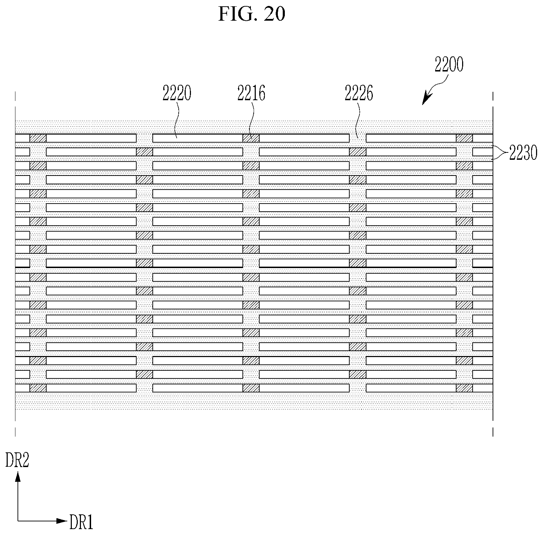

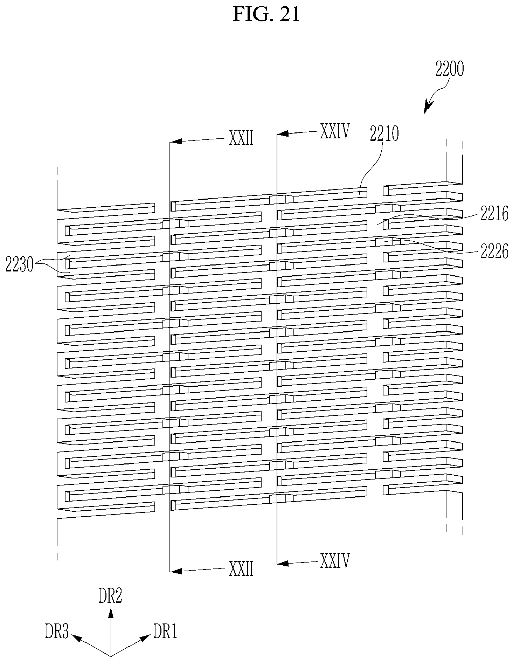

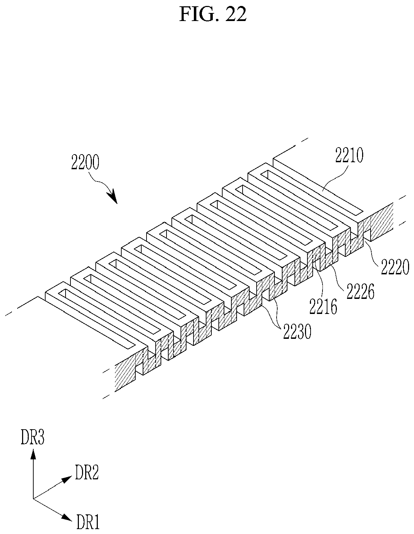

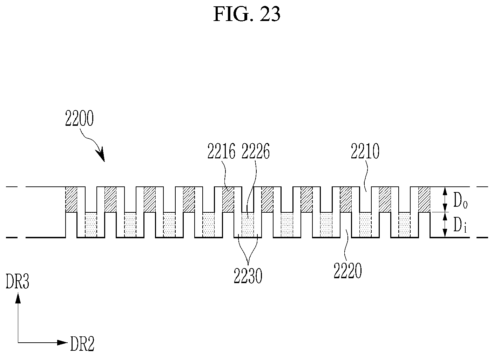

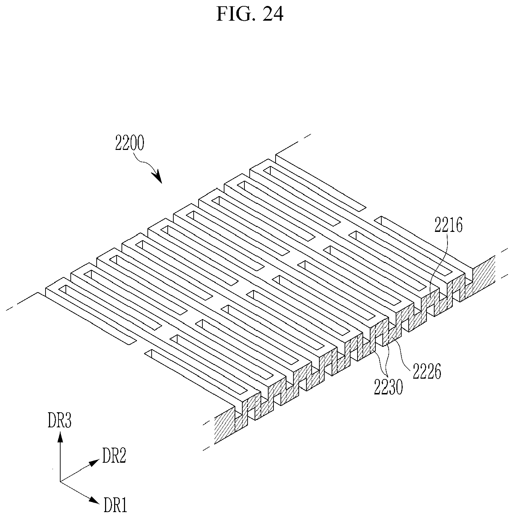

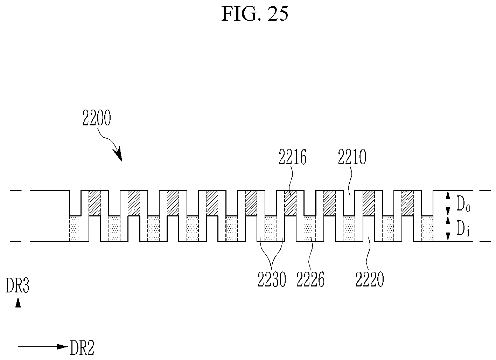

FIG. 19 illustrates a top plan view of one surface of a partial area of a support member for a display device according to an embodiment. FIG. 20 illustrates a top plan view of another surface of a partial area of a support member for a display device according to an embodiment. FIG. 19 and FIG. 20 illustrate the third area of the support member for the display device in more detail according to one or more embodiments. FIG. 19 illustrates the first surface, or in other words, the outer surface, of the support member for the display device, and FIG. 20 illustrates the second surface, or in other words, the inner surface, of the support member for the display device. FIG. 21 illustrates a perspective view of a partial area of a support member of a display device according to an embodiment. FIG. 22 illustrates a view taken along the line XXII-XXII of FIG. 21, and FIG. 23 illustrates a cross-sectional view taken along the line XXII-XXII of FIG. 21. FIG. 24 illustrates a view taken along the line XXIV-XXIV of FIG. 21, and FIG. 25 illustrates a cross-sectional view taken along the line XXIV-XXIV of FIG. 21.

Referring to FIG. 19, a support member 2200 for the display device according to an embodiment includes an outer pattern 2210 positioned in the third area. The outer pattern 2210 may be positioned at (e.g., in or on) the first surface of the support member 2200. The outer pattern 2210 may have a groove shape recessed to have a suitable depth (e.g., a predetermined depth) from a surface of the first surface of the support member 2200. The outer pattern 2210 may extend longer in the first direction DR1 in a plan view. The outer pattern 2210 may have a bar shape extending longer in the first direction DR1 in a plan view. The support member 2200 may include a plurality of outer patterns 2210. The plurality of outer patterns 2210 may be disposed along the first direction DR1 and the second direction DR2. In this case, a plurality of outer patterns 2210 that are adjacent to each other in the first direction DR1 may be disposed in a line, and a plurality of outer patterns 2210 that are adjacent to each other in the second direction DR2 may not be disposed in a line, and may be disposed in a zigzag manner.

The support member 2200 may include a plurality of ribs 2230 extending longer in the first direction DR1, and outer bridges 2216 connecting the ribs 2230 to each other. The ribs 2230 may be positioned between the plurality of outer patterns 2210 that are adjacent to each other in the second direction DR2. In other words, the plurality of outer patterns 2210 that are adjacent to each other in the second direction DR2 are separated from each other by the ribs 2230. The outer bridge 2216 may be positioned between the plurality of outer patterns 2210 that are adjacent to each other in the first direction DR1. In other words, the plurality of outer patterns 2210 that are adjacent to each other in the first direction DR1 are separated from each other by the outer bridges 2216.

Referring to FIG. 20, the support member 2200 for the display device according to an embodiment includes an inner pattern 2220 positioned in the third area. The inner pattern 2220 may be positioned at (e.g., in or on) the second surface of the support member 2200. The inner pattern 2220 may have a groove shape recessed to have a suitable depth (e.g., a predetermined depth) from a surface of the second surface of the support member 2200. The inner pattern 2220 may extend longer in the first direction DR1 in a plan view. The inner pattern 2220 may have a bar shape extending longer in the first direction DR1 in a plan view. The support member 2200 may include a plurality of inner patterns 2220. The plurality of inner patterns 2220 may be disposed along the first direction DR1 and the second direction DR2. In this case, a plurality of inner patterns 2220 that are adjacent to each other in the first direction DR1 may be disposed in a line, and a plurality of inner patterns 2220 that are adjacent to each other in the second direction DR2 may not be disposed in a line, and may be disposed in a zigzag manner.

The support member 2200 may include a plurality of ribs 2230 extending longer in the first direction DR1, and inner bridges 2226 connecting the ribs 2230 to each other. The ribs 2230 may be positioned between the plurality of inner patterns 2220 that are adjacent to each other in the second direction DR2. In other words, the plurality of inner patterns 2220 that are adjacent to each other in the second direction DR2 are separated from each other by the ribs 2230. The inner bridge 2226 may be positioned between the plurality of inner patterns 2220 that are adjacent to each other in the first direction DR1. In other words, the plurality of inner patterns 2220 that are adjacent to each other in the first direction DR1 are separated from each other by the inner bridges 2226.

The outer pattern 2210 and the inner pattern 2220 may be disposed to be staggered. Accordingly, at the first surface of the support member 2200, the outer pattern 2210 and the inner bridge 2226 may overlap with each other. In addition, at the second surface of the support member 2200, the inner pattern 2220 and the outer bridge 2216 may overlap with each other. The outer pattern 2210 and the inner pattern 2220 may overlap with each other in at least a partial area. A hole passing through (e.g., penetrating) the support member 2200 may be formed at a position at which the outer pattern 2210 and the inner pattern 2220 overlap with each other.

In the embodiments described above, the outer bridge and the inner bridge may be disposed in a zigzag shape. In the present embodiment, the outer bridge 2216 and the inner bridge 2226 may be disposed in a line along the second direction DR2. In other words, the outer bridge 2216 and the inner bridge 2226 may be positioned along an imaginary line extending in the second direction DR2.

Referring to FIG. 21 through FIG. 25, the support member 2200 of the display device according to one or more embodiments includes the outer pattern 2210 and the inner pattern 2220 that are disposed to be staggered. Between the outer patterns 2210, the rib 2230 and the outer bridge 2216 may be positioned. Between the inner patterns 2220, the rib 2230 and the inner bridge 2226 may be positioned. Referring to an end portion of the support member 2200, end portions of the ribs 2230 may be connected to each other by the outer bridge 2216. The inner bridge 2216 may not be positioned at an end portion of the support member 2200.

The ribs 2230 that are adjacent to each other may be connected to each other by the outer bridge 2216. In this case, the inner pattern 2220 may have a shape surrounded (e.g., around a periphery thereof) by the ribs 2230 and the outer bridge 2216. In addition, the ribs 2230 that are adjacent to each other may be connected to each other by the inner bridge 2226. In this case, the outer pattern 2210 may have a shape surrounded (e.g., around a periphery thereof) by the ribs 2230 and the inner bridge 2226. In addition, the outer pattern 2210 and the inner pattern 2220 may overlap with each other to form a hole.

The depth Dₒ of the outer pattern 2210 may correspond to the thickness of the outer bridge 2216. The depth Dᵢ of the inner pattern 2220 may correspond to the thickness of the inner bridge 2226. A sum of the depth Dₒ of the outer pattern 2210 and the depth Dᵢ of the inner pattern 2220 may correspond to the thickness of the support member 2200. The depth Dₒ of the outer pattern 2210 and the depth Dᵢ of the inner pattern 2220 are shown as being similar to (e.g., the same or substantially the same as) each other, but the present disclosure is not limited thereto. The depth of the outer pattern 2210 and the depth of the inner pattern 2220 may be the same or substantially the same as each other, or may be different from each other. For example, a ratio of the depth of the outer pattern 2210 to the thickness of the support member 2220 may be about 60% or more, and about 70% or less. In this case, a ratio of the depth of the inner pattern 2220 to the thickness of the support member 2220 may be about 30% or more, and about 40% or less.

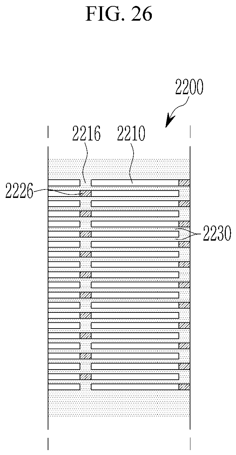

Hereinafter, a support member for a display device according to an embodiment will be described in more detail with reference to FIG. 26.

Because many portions of the support member for the display device according to the embodiment illustrated in FIG. 26 are the same or substantially the same as those of the embodiments of the support member described above with reference to FIG. 19 to FIG. 25, redundant description thereof may not be repeated. The present embodiment may be different from those described above, in that end portions of the ribs may be entirely connected to each other, which will be described in more detail below.

FIG. 26 illustrates a top plan view of a partial area of a support member for a display device according to an embodiment.

As shown in FIG. 26, the support member 2200 for the display device according to an embodiment includes the outer pattern 2210 and the inner pattern 2220 that are disposed to be staggered. Between the outer patterns 2210, the rib 2230 and the outer bridge 2216 may be positioned. Between the inner patterns 2220, the rib 2230 and the inner bridge 2226 may be positioned.

In one or more embodiments described above, some end portions of the ribs 2230 of the support member 2200 may be connected to each other, and some other end portions of the ribs 2230 may not be connected to each other. In the present embodiment, the end portions of the ribs 2230 of the support member 2200 may be connected to each other as a whole. In one or more embodiments described above, the end portions of the ribs 2230 of the support member 2200 are connected to each other by the outer bridge 2216, and in the present embodiment, the end portions of the ribs 2230 of the support member 2200 may be connected to each other by the outer bridge 2216 and the inner bridge 2226. In other words, the outer bridge 2216 and the inner bridge 2226 may be alternately disposed along a line at the end portion of the support member 2200.

However, the present disclosure is not limited thereto, and the end portions of the ribs 2230 of the support member 2200 may not be connected to each other. In other words, the bridge may not be positioned at any of the end portions of the support member 2200. In this case, the outer pattern 2210 and the inner pattern 2220 positioned at the end portions of the support member 2200 may be opened.

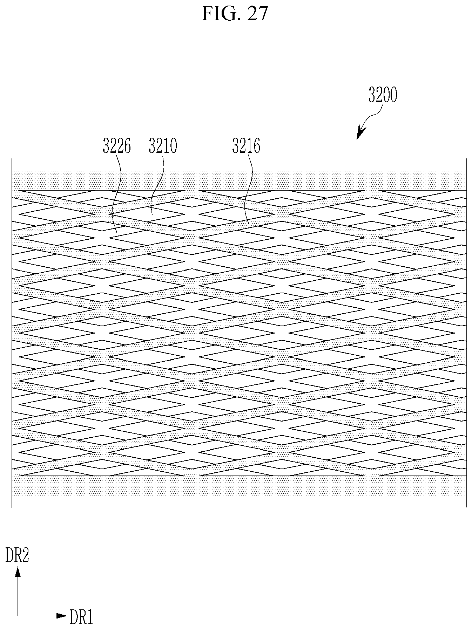

Hereinafter, a support member for a display device according to one or more embodiments will be described in more detail with reference to FIG. 27 through FIG. 31.

Because many portions of the support member for the display device according to the embodiments illustrated in FIG. 27 to FIG. 31 are the same or substantially the same as those of the embodiments of the support member described above with reference to FIG. 4 to FIG. 13, redundant description thereof may not be repeated. In the present embodiment, the shapes of the outer pattern and the inner pattern may be different from those described above, which will be described in more detail below.

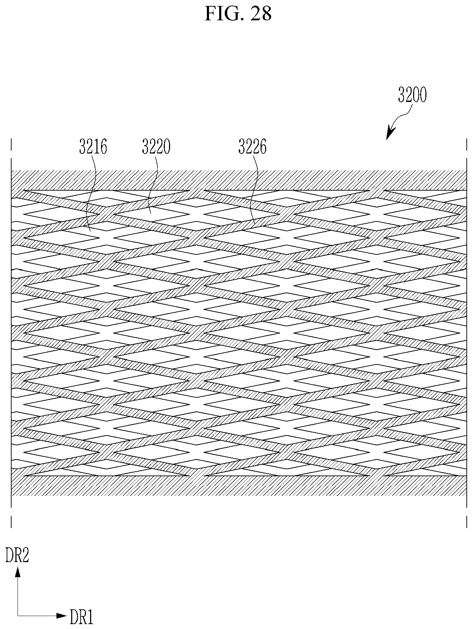

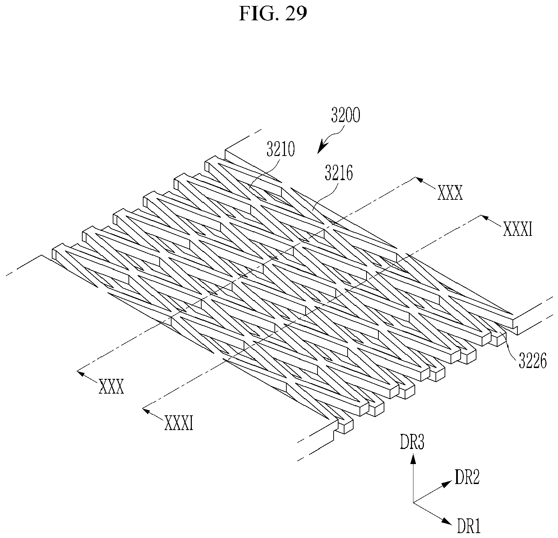

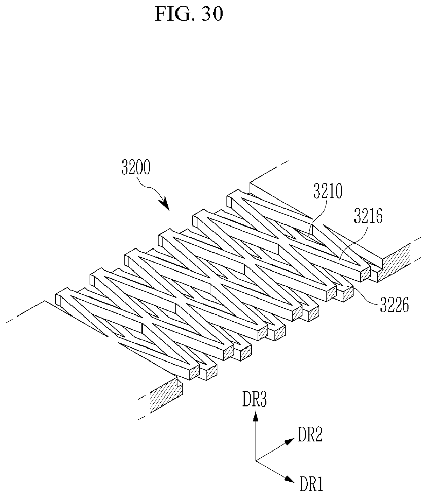

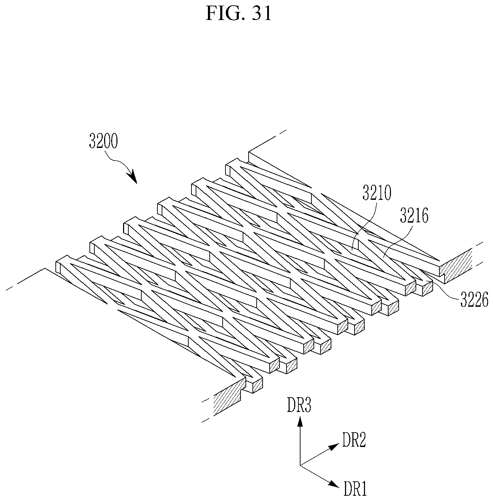

FIG. 27 illustrates a top plan view of one surface of a partial area of a support member for a display device according to an embodiment. FIG. 28 illustrates a top plan view of another surface of a partial area of a support member for a display device according to an embodiment. FIG. 27 and FIG. 28 illustrate the third area of the support member for the display device in more detail according to one or more embodiments. FIG. 27 illustrates the first surface, or in other words, the outer surface, of the support member for the display device according to an embodiment, and FIG. 28 illustrates the second surface, or in other words, the inner surface, of the support member for the display device according to an embodiment. FIG. 29 illustrates a perspective view of a partial area of a support member of a display device according to an embodiment. FIG. 30 illustrates a view taken along the line XXX-XXX of FIG. 29, and FIG. 31 illustrates a view taken along the line XXXI-XXXI of FIG. 29.

Referring to FIG. 27, a support member 3200 for the display device according to an embodiment includes an outer pattern 3210 positioned in the third area. The outer pattern 3210 may be positioned at (e.g., in or on) the first surface of the support member 3200. The outer pattern 3210 may have a groove shape recessed to have a suitable depth (e.g., a predetermined depth) from a surface of the first surface of the support member 3200. The outer pattern 3210 may extend longer in the first direction DR1 in a plan view. The outer pattern 3210 may have a rhombus shape in a plan view. The outer pattern 3210 may have a rhombus shape including a diagonal length parallel to or substantially parallel to the first direction DR1 and a diagonal length parallel to or substantially parallel to the second direction DR2. In this case, a length of the diagonal length parallel to or substantially parallel to the first direction DR1 may be longer than a length of the diagonal length parallel to or substantially parallel to the second direction DR2. The support member 3200 may include a plurality of outer patterns 3210. The plurality of outer patterns 3210 may be disposed along the first direction DR1 and the second direction DR2.

The support member 3200 may include an outer bridge 3216 that separates the plurality of outer patterns 3210 from each other. The outer bridge 3216 may have a mesh shape, and may extend in a direction oblique to the first direction DR1 and the second direction DR2.

Referring to FIG. 28, the support member 3200 for the display device according to an embodiment includes an inner pattern 3220 positioned in the third area. The inner pattern 3220 may be positioned at (e.g., in or on) the second surface of the support member 3200. The inner pattern 3220 may have a groove shape recessed to have a suitable depth (e.g., a predetermined depth) from a surface of the second surface of the support member 3200. The inner pattern 3220 may extend longer in the first direction DR1 in a plan view. The inner pattern 3220 may have a rhombus shape in a plan view. The inner pattern 3220 may have a rhombus shape including a diagonal length parallel to or substantially parallel to the first direction DR1, and a diagonal length parallel to or substantially parallel to the second direction DR2. In this case, a length of the diagonal parallel to or substantially parallel to the first direction DR1 may be longer than a length of the diagonal parallel to or substantially parallel to the second direction DR2. The support member 3200 may include a plurality of inner patterns 3220. The plurality of inner patterns 3220 may be disposed along the first direction DR1 and the second direction DR2.

The support member 3200 may include an inner bridge 3226 that separates the plurality of inner patterns 3220 from each other. The inner bridge 3226 may have a mesh shape, and may extend in a direction oblique to the first direction DR1 and the second direction DR2.

The outer pattern 3210 and the inner pattern 3220 may be disposed to be staggered. Accordingly, at the first surface of the support member 3200, the outer pattern 3210 and the inner bridge 3226 overlap with each other. In addition, at the second surface of the support member 3200, the inner pattern 3220 and the outer bridge 3216 overlap each other. The outer pattern 3210 and the inner pattern 3220 may overlap with each other in at least a partial area. A hole passing through (e.g., penetrating) the support member 3200 may be formed at a position at which the outer pattern 3210 and the inner pattern 3220 overlap with each other. A hole formed by overlapping the outer pattern 3210 and the inner pattern 3220 with each other may have a rhombus shape in a plan view.

Referring to FIG. 29 through FIG. 31, the support member 3200 of the display device according to one or more embodiments includes the outer pattern 3210 and the inner pattern 3220 that are disposed to be staggered. Between the outer patterns 3210, the outer bridge 3216 may be positioned. Between the inner patterns 3220, the inner bridge 3226 may be positioned.

Referring to an end portion of the support member 3200, a portion of the outer pattern 3210 is closed, and another portion of the outer pattern 3210 is opened. In addition, a portion of the inner pattern 3220 positioned at the end portion of the support member 3200 is closed, and another portion of the inner pattern 3220 is opened. However, the present disclosure is not limited thereto, and both the outer pattern 3210 and the inner pattern 3220 positioned at the end portion of the support member 3200 may be closed. As another example, both the outer pattern 3210 and the inner pattern 3220 positioned at the end portion of the support member 3200 may be opened.

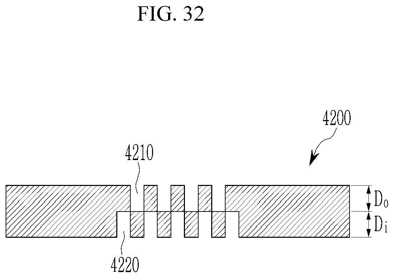

The outer pattern and the inner pattern formed in the third area of the support member for the display device according to the embodiments of the present disclosure may be variously modified as needed or desired, in addition to the various embodiments described above. Hereinafter, various modified examples of a support member for a display device according to one or more embodiments will be described in more detail below with reference to FIG. 32 through FIG. 37.

FIG. 32 through FIG. 37 illustrate cross-sectional views of a partial area of a support member for a display device according to one or more embodiments. FIG. 32 through FIG. 37 illustrate an area in which a support member for a display device according to one or more embodiments is folded, and a periphery thereof.

Referring to FIG. 32, a support member 4200 for a display device according to an embodiment includes an outer pattern 4210 and an inner pattern 4220 respectively formed at (e.g., in or on) two surfaces opposite to each other. In a state in which the support member 4200 for the display device is folded, a surface at (e.g., in or on) which the outer pattern 4210 is formed may be an outer surface, and a surface at (e.g., in or on) which the inner pattern 4220 is formed may be an inner surface. However, the present disclosure is not limited thereto, and the surface at (e.g., in or on) which the outer pattern 4210 is formed may be an inner surface, and the surface at (e.g., in or on) which the inner pattern 4220 is formed may be an outer surface.

The outer pattern 4210 and the inner pattern 4220 are disposed to be staggered. The outer pattern 4210 and the inner pattern 4220 may not overlap with each other. The outer pattern 4210 and the inner pattern 4220 may overlap with each other in some areas, and may not overlap with each other in some other areas. The depth Dₒ of the outer pattern 4210 and the depth Dᵢ of the inner pattern 4220 are shown as being similar to (e.g., the same or substantially the same as) each other, but the present disclosure is not limited thereto. The depth Dₒ of the outer pattern 4210 and the depth Dᵢ of the inner pattern 4220 may be the same or substantially the same as each other, or may be different from each other. For example, the depth Dₒ of the outer pattern 4210 may be larger than the depth Dᵢ of the inner pattern 4220.

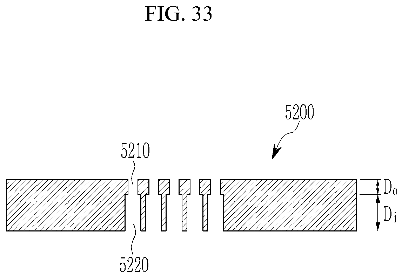

Referring to FIG. 33, a support member 5200 for a display device according to an embodiment includes an outer pattern 5210 and an inner pattern 5220 respectively formed at (e.g., in or on) two surfaces opposite to each other. In a state in which the support member 5200 for the display device is folded, a surface at (e.g., in or on) which the outer pattern 5210 is formed may be an outer surface, and a surface at (e.g., in or on) which the inner pattern 5220 is formed may be an inner surface. However, the present disclosure is not limited thereto, and the opposite may be possible.

The outer pattern 5210 and the inner pattern 5220 may overlap with each other. The outer pattern 5210 and the inner pattern 5220 may overlap with each other in some areas, and may not overlap with each other in some other areas. The width of the outer pattern 5210 and the width of the inner pattern 5220 may be different from each other. As shown in FIG. 33, the width of the outer pattern 5210 may be narrower than the width of the inner pattern 5220. However, the present disclosure is not limited thereto, and the width of the outer pattern 5210 may be wider than the width of the inner pattern 5220. The depth Dₒ of the outer pattern 5210 and the depth Dᵢ of the inner pattern 5220 may be different from each other. As shown in FIG. 33, the depth Dₒ of the outer pattern 5210 may be smaller than the depth Dᵢ of the inner pattern 5220. However, the present disclosure is not limited thereto, and the depth Dₒ of the outer pattern 5210 may be larger than the depth Dᵢ of the inner pattern 5220.

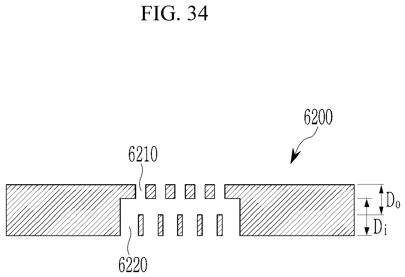

Referring to FIG. 34, a support member 6200 for a display device according to an embodiment includes an outer pattern 6210 and an inner pattern 6220 respectively formed at (e.g., in or on) two surfaces opposite to each other. In a state in which the support member 6200 for the display device is folded, a surface at (e.g., in or on) which the outer pattern 6210 is formed may be an outer surface, and a surface at (e.g., in or on) which the inner pattern 6220 is formed may be an inner surface. However, the present disclosure is not limited thereto, and the opposite may also be possible.

The outer pattern 6210 and the inner pattern 6220 may not overlap with each other. The outer pattern 6210 and the inner pattern 6220 may overlap with each other in some areas, and may not overlap with each other in some other areas. The width of the outer pattern 6210 and the width of the inner pattern 6220 may be different from each other. As shown in FIG. 34, the width of the outer pattern 6210 may be narrower than the width of the inner pattern 6220. However, the present disclosure is not limited thereto, and the width of the outer pattern 6210 may be wider than the width of the inner pattern 6220.

As described above, the sum of the depth of the outer pattern and the depth of the inner pattern may correspond to the thickness of the support member, but in the present embodiment, the sum of the depth Dₒ of the outer pattern 6210 and the depth Dᵢ of the inner pattern 6220 may be larger than the thickness of the support member 6200. The depth Dₒ of the outer pattern 6210 and the depth Dᵢ of the inner pattern 6220 may be the same or substantially the same as each other, or may be different from each other.

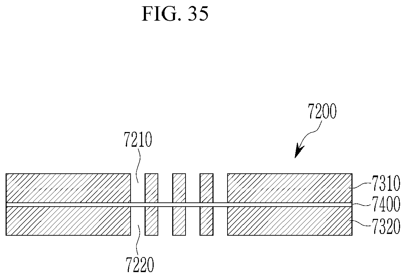

Referring to FIG. 35, a support member 7200 for a display device according to an embodiment includes an outer pattern 7210 and an inner pattern 7220 respectively formed at (e.g., in or on) two surfaces opposite to each other. In a state in which the support member 7200 for the display device is folded, a surface at (e.g., in or on) which the outer pattern 7210 is formed may be an outer surface, and a surface at (e.g., in or on) which the inner pattern 7220 is formed may be an inner surface. However, the present disclosure is not limited thereto, and the opposite may also be possible. The outer pattern 7210 and the inner pattern 7220 may overlap with each other.

The support member 7200 for the display device according to the present embodiment may include a first sub-support member 7310 and a second sub-support member 7320. The first sub-support member 7310 and the second sub-support member 7320 may overlap with each other. The support member 7200 for the display device may further include an adhesive member 7400 positioned between the first sub-support member 7310 and the second sub-support member 7320. The first sub-support member 7310 may be fixed to the second sub-support member 7320 by the adhesive member 7400.

The outer pattern 7210 may be formed at (e.g., in or on) the first sub-support member 7310, and the inner pattern 7220 may be formed at (e.g., in or on) the second sub-support member 7320. The adhesive member 7400 is positioned between the outer pattern 7210 and the inner pattern 7220. Accordingly, a hole passing through (e.g., penetrating) the support member 7200 may not be formed at a portion in which the outer pattern 7210 and the inner pattern 7220 overlap with each other.

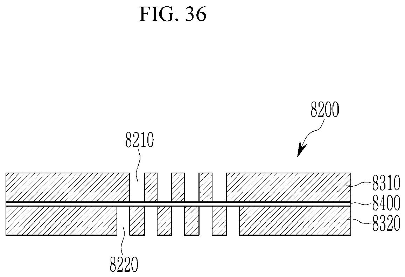

Referring to FIG. 36, a support member 8200 for a display device according to an embodiment includes an outer pattern 8210 and an inner pattern 8220 respectively formed at (e.g., in or on) two surfaces opposite to each other. In a state in which the support member 8200 for the display device is folded, a surface at (e.g., in or on) which the outer pattern 8210 is formed may be an outer surface, and a surface at (e.g., in or on) which the inner pattern 8220 is formed may be an inner surface. However, the present disclosure is not limited thereto, and the opposite may also be possible. The outer pattern 8210 and the inner pattern 8220 may not overlap with each other.

The support member 8200 for the display device according to the present embodiment may include a first sub-support member 8310 and a second sub-support member 8320. The first sub-support member 8310 and the second sub-support member 8320 may overlap with each other. The support member 8200 for the display device may further include an adhesive member 8400 positioned between the first sub-support member 8310 and the second sub-support member 8320. The first sub-support member 8310 may be fixed to the second sub-support member 8320 by the adhesive member 8400.

The outer pattern 8210 may be formed at (e.g., in or on) the first sub-support member 8310, and the inner pattern 8220 may be formed at (e.g., in or on) the second sub-support member 8320. The adhesive member 8400 is positioned between the outer pattern 8210 and the inner pattern 8220.

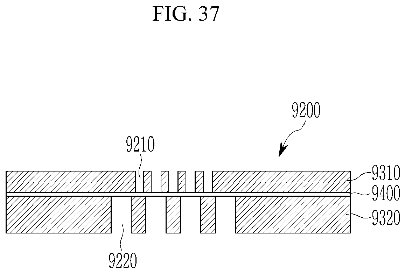

Referring to FIG. 37, a support member 9200 for a display device according to an embodiment includes an outer pattern 9210 and an inner pattern 9220 respectively formed at (e.g., in or on) two surfaces opposite to each other. In a state in which the support member 9200 for the display device is folded, a surface at (e.g., in or on) which the outer pattern 9210 is formed may be an outer surface, and a surface at (e.g., in or on) which the inner pattern 9220 is formed may be an inner surface. However, the present disclosure is not limited thereto, and the opposite may also be possible. The outer pattern 9210 and the inner pattern 9220 may not overlap with each other. The outer pattern 9210 and the inner pattern 9220 may overlap with each other in some areas, and may not overlap with each other in some other areas.

The support member 9200 for the display device according to the present embodiment may include a first sub-support member 9310 and a second sub-support member 9320. The first sub-support member 9310 and the second sub-support member 9320 may overlap with each other. The support member 9200 for the display device may further include an adhesive member 9400 positioned between the first sub-support member 9310 and the second sub-support member 9320. The first sub-support member 9310 may be fixed to the second sub-support member 9320 by the adhesive member 9400.

The outer pattern 9210 may be formed at (e.g., in or on) the first sub-support member 9310, and the inner pattern 9220 may be formed at (e.g., in or on) the second sub-support member 9320. The adhesive member 9400 is positioned between the outer pattern 9210 and the inner pattern 9220.

The width of the outer pattern 9210 and the width of the inner pattern 9220 may be different from each other. As shown in FIG. 37, the width of the outer pattern 9210 may be narrower than the width of the inner pattern 9220. However, the present disclosure is not limited thereto, and the width of the outer pattern 9210 may be wider than the width of the inner pattern 9220.

The depth of the outer pattern 9210 and the depth of the inner pattern 9220 may be different from each other. As shown in FIG. 37, the depth of the outer pattern 9210 may be smaller than the depth of the inner pattern 9220. However, the present disclosure is not limited thereto, and the depth of the outer pattern 9210 may be larger than the depth of the inner pattern 9220.

Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

### Description of symbols

100: display panel
200: support member
201: first surface of support member
202: second surface of support member
210: outer pattern
216: outer bridge
220: inner pattern
226: inner bridge
230: rib

## Claims

1. A support member for a display device, comprising:
a first surface and a second surface opposite to each other;
an outer pattern at the first surface, and extending longer in a first direction; and
an inner pattern at the second surface, and extending longer in the first direction,
wherein the outer pattern and the inner pattern are staggered with each other.

2. The support member of claim 1, wherein:
the support member comprises a first area, a second area, and a third area between the first area and the second area in a plan view;
the support member is configured to be folded along a folding axis parallel to the first direction in the third area; and
the outer pattern and the inner pattern are located in the third area.

3. The support member claim 2, wherein in a state in which the support member is folded, the first surface faces toward the outside, and the second surface faces toward the inside.

4. The support member of claim 2 or claim 3, wherein:
the outer pattern has a shape of a groove recessed from the first surface of the support member;
the inner pattern has a shape of a groove recessed from the second surface of the support member; and
a hole penetrating the support member is located in a portion in which the outer pattern and the inner pattern overlap with each other.

5. The support member of any one of claims 2 to 4, wherein the outer pattern and the inner pattern have a bar shape or a rhombus shape in a plan view.

6. The support member of any one of claims 2 to 5, wherein:
the outer pattern comprises a plurality of outer patterns adjacent to one another along the first direction, and a second direction crossing the first direction; and
the inner pattern comprises a plurality of inner patterns adjacent to one another along the first direction and the second direction.

7. The support member of claim 6, further comprising:
an outer bridge between the plurality of the outer patterns; and
an inner bridge between the plurality of the inner patterns.

8. The support member of claim 7, wherein:
(i) the outer bridge and the inner bridge are located in a zigzag shape; or
(ii) the outer bridge and the inner bridge are located along an imaginary line extending in the second direction.

9. The support member of any one of claims 2 to 8, wherein:
a ratio of a depth of the outer pattern to a thickness of the support member is 60% or more, and 70% or less; and
a ratio of a depth of the inner pattern to the thickness of the support member is 30% or more, and 40% or less.

10. The support member of any one of claims 2 to 4, wherein:
a width of the outer pattern decreases as a depth of the outer pattern increases from the first surface; and
a width of the inner pattern decreases as a depth of the inner pattern increases from the second surface.

11. The support member of claim 2, wherein:
the support member comprises a first sub-support member and a second sub-support member that overlap with each other;
the outer pattern is located at the first sub-support member; and
the inner pattern is located at the second sub-support member, optionally further comprising an adhesive member between the first sub-support member and the second sub-support member.

12. A display device comprising:
a display panel configured to display an image; and
a support member on one surface of the display panel,
wherein the support member comprises:
a first surface and a second surface opposite to each other;
an outer pattern at the first surface, and extending longer in a first direction; and
an inner pattern at the second surface, and extending longer in the first direction, and
wherein the outer pattern and the inner pattern are staggered with each other.

13. The display device of claim 12, wherein:
the support member comprises a first area, a second area, and a third area between the first area and the second area in a plan view;
the support member is configured to be folded along a folding axis parallel to the first direction in the third area; and
the outer pattern and the inner pattern are located in the third area.

14. The display device of claim 13, wherein:
(i) in a state in which the support member is folded, the first surface faces toward the outside, and the second surface faces toward the inside; and/or
(ii) the outer pattern has a shape of a groove recessed from the first surface of the support member;
the inner pattern has a shape of a groove recessed from the second surface of the support member; and
a hole penetrating the support member is located in a portion in which the outer pattern and the inner pattern overlap with each other; and/or
(iii) the outer pattern and the inner pattern have a bar shape or a rhombus shape in a plan view.

15. The display device of any one of claims 12 to 14, wherein:
the outer pattern comprises a plurality of outer patterns adjacent to one another along the first direction, and a second direction crossing the first direction; and
the inner pattern comprises a plurality of inner patterns adjacent to one another along the first direction and the second direction, optionally wherein:
the support member comprises:
an outer bridge between the plurality of outer patterns; and
an inner bridge between the plurality of inner patterns, and
wherein the outer bridge and the inner bridge are located in a zigzag shape, or along a line.
